# EUROPÄISCHE PATENTSCHRIFT

(11) **EP 2 466 613 B1**
(45) Veröffentlichungstag und Bekanntmachung des Hinweises auf die Patenterteilung: **02.08.2017**
(21) Anmeldenummer: 11009523.9
(22) Anmeldetag: 02.12.2011
(51) Int. Cl.: H01J 37/153, H01J 37/28

(54) **Korrektor**
Corrector
Correcteur

(30) Priorität: 15.12.2010 DE 102010054541
(43) Veröffentlichungstag der Anmeldung: 20.06.2012
(73) Patentinhaber: Ceos Corrected Electron Optical Systems GmbH, 69126 Heidelberg (DE)
(72) Erfinder: Zach, Joachim, Dr., 76684 Östringen (DE); Uhlemann, Stephan, Dr., 69115 Heidelberg (DE)
(74) Vertreter: Weber & Seidel

(56) Entgegenhaltungen:
- DE-A1- 4 204 512
- US-A1- 2008 283 749

## Beschreibung

Die Erfindung betrifft einen Korrektor für die Farb- und Öffnungsfehlerkorrektur bei einem Elektronenmikroskop mit im Strahlengang nacheinander symmetrisch zu einer Symmetrieebene angeordneten sechs Multipolelementen, von denen alle zur Erzeugung von Quadrupolfeldern und das dritte und vierte auch zur Erzeugung von Oktupolfeldern dienen, wobei letztere gleichgerichtet und die Quadrupolfelder aller sechs Multipolelemente von einem zum nächsten um 90° gedreht und bezüglich ihrer Feldstärken (nicht ihrer Polarität) punktsymmetrisch zum Schnittpunkt der optischen Achse mit der Symmetrieebene sind, wobei die folgenden Austauschsymmetrien entstehen, eine Austauschsymmetrie der axialen Fundamentalbahnen mit der Symmetrieebene als Spiegelebene für den Austausch des Verlaufs der axialen Fundamentalbahnen, sowie eine Austauschsymmetrie der außeraxialen Fundamentalbahnen mit dem Schnittpunkt der optischen Achse mit der Symmetrieebene als Punkt für einen punktsymmetrischen Austausch des Verlaufs der außeraxialen Fundamentalbahnen, und wobei danach alle Fundamentalbahnen am Ende des Korrektors wieder zusammengeführt werden, wobei durch das Zusammenwirken der als magnetische und elektrische Felder ausgebildeten Quadrupolfelder des dritten und vierten Multipolelements eine Farbfehlerkorrektur sowie mittels der Quadrupolfelder und der Oktupolfelder eine Öffnungsfehlerkorrektur möglich ist.

Der Zweck eines derartigen Korrektors besteht darin, daß die Farb- und Öffnungsfehler der optischen Bauteile des Mikroskops kompensierbar sind. Durch die Kompensation mittels solcher Korrektoren werden aber nicht nur Fehler von Strahlquelle und Linsen des Elektronenmikroskops kompensiert, sondern auch Fehler, die der Korrektor selbst verursacht.

Die Grundlage für die Funktion aller Korrektoren in der Teilchenoptik bildet die Erkenntnis von O. Scherzer (O. Scherzer: "Sphärische und chromatische Korrektur von Elektronen-Linsen" OPTIK, DE, JENA, 1947, Seiten 114-132, XP002090897, ISSN: 0863-0259), daß auch bei Teilchenstrahlen die Korrektur von Farb- und Öffnungsfehlern möglich ist, wenn man nicht-rotationssymmetrische Felder einsetzt, mit denen astigmatische Zwischenbilder erzeugt und dann dieser Astigmatismus wieder beseitigt wird. O. Scherzer stellt die Bedingungen auf, unter denen dies erreichbar ist (a.a.O.). Diese als Scherzer-Theorem bezeichneten Bedingungen sind Grundlage jeder Farb- und Öffnungsfehlerkorrektur in der Teilchenoptik.

Aus der DE 10 2007 049 816 B3 ist ein aus fünf Multipolelementen bestehender Korrektor bekannt, der jedoch in nicht unbedeutendem Maß Fehler höherer Ordnung selbst verursacht, was die Fehlerkompensation erschwert.

Die DE 42 04 512 A1 hat einen Korrektor der eingangs genannten Art vorgeschlagen, der zwar weniger Fehler höherer Ordnung verursacht, jedoch bezüglich Feldschwankungen der Quadrupolfelder äußerst empfindlich ist. Diese auch als "Rauschen" bezeichneten Feldschwankungen rühren von Schwankungen der Strom- bzw. Spannungsversorgung her. Die Empfindlichkeit gegenüber diesen Schwankungen erwiesen sich in der Testphase eines nach dieser Schrift gebauten Korrektors als so groß, daß es nicht mit vernünftigem technischen Aufwand möglich war, diese Empfindlichkeit durch hochstabile Versorgung mit elektrischer Energie in den Griff zu bekommen. Deshalb wurde die Realisierung dieses Korrektors einschließlich der oben genannten Patentanmeldung aufgegeben.

Der Erfindung liegt daher die Aufgabe zugrunde, einen Korrektor der eingangs genannten Art derart weiterzuentwickeln, daß er gegenüber Schwankungen der elektrischen Energieversorgung unempfindlich ist.

Die Aufgabe wird erfindungsgemäß dadurch gelöst, daß im Quadrupolfeld des ersten Quadrupolelements ein stigmatisches Zwischenbild der axialen Fundamentalbahnen entsteht und dieses Quadrupolfeld derart eingestellt ist, daß astigmatische Zwischenbilder der außeraxialen Fundamentalbahnen im Bereich der Mitte der Quadrupolfelder des dritten und vierten Multipolelements entstehen und dort auch durch die Einstellung des Quadrupolfeldes des zweiten Quadrupolelements die axialen Fundamentalbahnen des gleichen Schnitts, in dem die Zwischenbilder der außeraxialen Fundamentalbahnen liegen, jeweils ein Maximum aufweisen.

Der erfindungsgemäße Korrektor ist gegenüber Schwankungen der elektrischen Energieversorgung wesentlich unempfindlicher, wodurch entweder der Aufwand für eine hochstabile Energieversorgung wesentlich verringert wird und/oder die Verschlechterung der Bildqualität durch solche Schwankungen vermieden wird.

Diese Empfindlichkeit gegen Schwankungen der Energieversorgung und damit der Feldstärken der jeweiligen Felder resultiert aus der Bahnhöhe der Fundamentalbahnen in den jeweiligen Quadrupolen, wobei die Empfindlichkeit quadratisch mit der Bahnhöhe zunimmt. Insbesondere spielen dabei die axialen Fundamentalbahnen eine Rolle, die beim erfindungsgemäßen Korrektor im ersten Quadrupol durch den Nullpunkt gehen, da der Korrektor derart im Strahlgang eines Elektronenmikroskops angeordnet ist, daß im Quadrupolfeld des ersten Quadrupolelements ein stigmatisches Zwischenbild der axialen Fundamentalbahnen x_{α} und y_{β} entsteht. Diese steigen dann zum zweiten Quadrupol noch nicht sehr stark. Im Gegensatz dazu weisen die axialen Fundamentalbahnen beim Korrektor der DE 42 04 512 A1 im ersten Quadrupol schon eine relative Höhe auf, und die Fundamentalbahn y_{β} hat im zweiten Quadrupol sogar ein Maximum. Entsprechendes gilt natürlich wegen der Punktsymmetrie (auch Antisymmetrie genannt) der Felder auch für den fünften und sechsten Quadrupol. Für den Korrekturerfolg sind jedoch derartige Maxima nur im dritten beziehungsweise vierten Quadrupol erforderlich. Auf diese Weise ist bei dem erfindungsgemäßen Korrektor eine hochstabile Versorgung mit elektrischer Energie nur beim dritten und vierten Multipolelement erforderlich, da nur dort Quadrupolfelder benötigt werden, die nahezu frei von Feldstärkeschwankungen sind. Alle anderen Multipolelemente benötigen diese Präzision der Energieversorgung nicht, wodurch der Aufwand für die Versorgung mit elektrischer Energie wesentlich verringert wird beziehungsweise eine Beeinträchtigung von Bildqualität und Auflösungsvermögen durch solche Schwankungen der elektrischen Versorgungsenergie vermieden wird.

Auf diese Weise wird durch die Erfindung sowohl eine Bildbeeinträchtigung durch Schwankungen der Energieversorgung, wie bei dem Korrektor der DE 42 04 512 A1, als auch die Entstehung von Fehlern höherer Ordnung, wie bei dem Korrektor der DE 10 2007 049 816 B3, vermieden.

Alle Felder des ersten, zweiten, fünften und sechsten Multipolelements, sowie die Oktupolfelder des dritten und vierten Multipolelements können dabei magnetische oder elektrische Felder oder eine Kombination von beidem sein. Lediglich die Quadrupolfelder des dritten und vierten Multipolelements müssen zusammenwirkende elektrische und magnetische Felder sein.

Der erfindungsgemäße Korrektor geht zunächst von den vorbekannten Funktionen aus, daß nach der Lehre von O. Scherzer (a.a.O.) das Quadrupolfeld des ersten Multipolelements dem Strahl bezüglich der außeraxialen Fundamentalbahnen eine Abweichung von der Rotationssymmetrie aufprägt, so daß in zwei aufeinander senkrechten Hauptschnitten, dem x- und dem y-Schnitt, die Strahlen unterschiedlich divergierend verlaufen. Da die axialen Fundamentalbahnen im ersten Quadrupolfeld ein stigmatisches Zwischenbild aufweisen, bleibt deren Verlauf unbeeinflußt. Das nachfolgende, um 90° gedrehte Quadrupolfeld des zweiten Multipolelements bewirkt, daß auch die axialen Fundamentalbahnen divergierend verlaufen und beeinflußt gleichzeitig die Steigung der außeraxialen Fundamentalbahnen, wobei die Fundamentalbahn y_{δ} ein Maximum durchschreitet. Im dritten Multipolelement, das im Verhältnis zu den beiden ersteren ein stärkeres Quadrupolfeld erzeugt, tritt das erste Zwischenbild der außeraxialen Fundamentalbahnen auf und gleichzeitig ein Maximum von einer der axialen Fundamentalbahnen, die jeweils ungefähr im selben Bereich des dritten Quadrupolfeldes liegen. Diese Konstellation bewirkt eine wesentliche Verringerung der Kombinationsfehler 5. Ordnung.

Nach der Symmetrieebene zwischen dem dritten und vierten Multipolelement kommt es zu einer Austauschsymmetrie. Austauschsymmetrie in diesem Sinn heißt, daß ein Austausch der Strahlverläufe des x-Schnitts und des y-Schnitts stattfindet.

Dabei kann eine solche Austauschsymmetrie eine Spiegelsymmetrie sein. Dies ist bezüglich der axialen Fundamentalbahnen x_{α} und y_{β} der Fall. Das heißt, nach der Symmetrieebene verläuft die Fundamentalbahn y_{β} spiegelsymmetrisch zur Fundamentalbahn x_{α} vor der Symmetrieebene und umgekehrt.

Eine solche Austauschsymmetrie kann jedoch auch eine Punktsymmetrie oder Antisymmetrie sein. Das ist bezüglich der außeraxialen Fundamentalbahnen x_{γ} und y_{δ} der Fall. Das heißt, daß eine Punktsymmetrie bezüglich des Schnittpunktes der Symmetrieebene mit der optischen Achse eintritt, so daß die Fundamentalbahn y_{δ} nach der Symmetrieebene so verläuft, wie die Fundamentalbahn x_{γ} vor der Symmetrieebene, jedoch am Symmetriepunkt gespiegelt. Umgekehrt verläuft die Fundamentalbahn x_{γ} nach der Symmetrieebene so, wie die Fundamentalbahn y_{δ} vor der Symmetrieebene, jedoch ebenfalls punktgespiegelt.

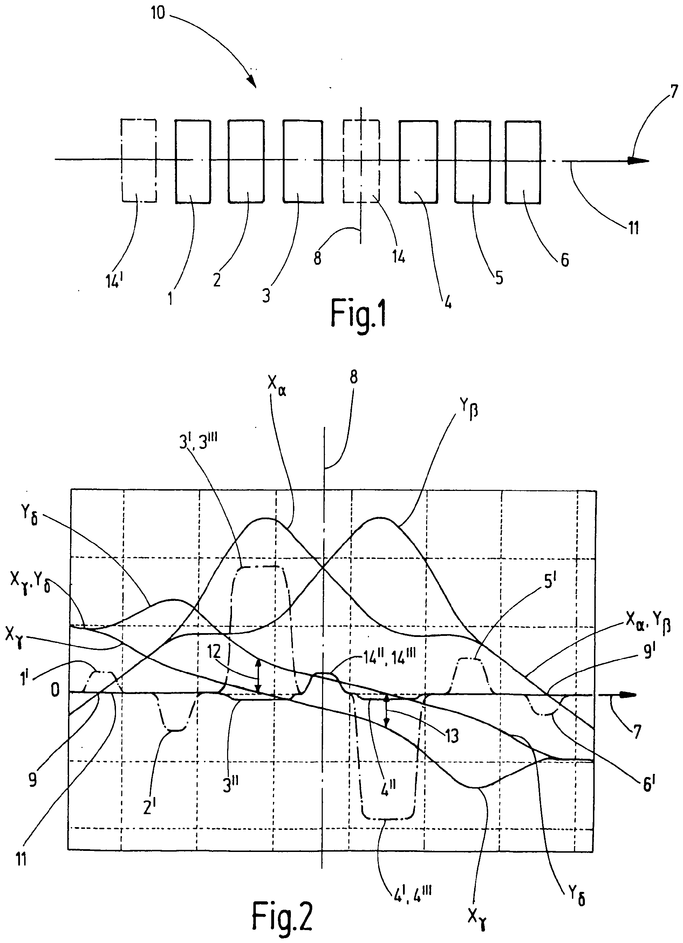

Damit tritt die oben beschriebene Konstellation auch im vierten Quadrupolfeld ein, nämlich, daß ein astigmatisches Zwischenbild der außeraxialen Fundamentalbahnen x_{γ} und y_{δ} (jetzt das zweite astigmatische Zwischenbild) ungefähr im selben Bereich wie ein Maximum einer axialen Fundamentalbahn liegt. Dabei weist das Quadrupolfeld ein umgekehrtes Vorzeichen auf, ist also um 90° gedreht. Entsprechend liegt dann dort das zweite astigmatische Zwischenbild um 90° gedreht (siehe Fig. 2). Dort wird dann die o. g. Korrektur in einem Bereich des Strahls bewirkt, der senkrecht zum vorgenannten Bereich liegt. Dies entspricht dem Prinzip von Scherzer, der Korrektur von Teilchenstrahlen durch die Deformierung des Strahls derart, daß dieser nacheinander im Bereich zweier senkrecht aufeinanderstehender Ebenen verläuft.

Durch die antisymmetrische bzw. punktsymmetrische Ausbildung der Quadrupolfelder, bei denen das erste und das sechste, das zweite und das fünfte und das dritte und das vierte jeweils betragsgleich, aber entgegengesetzt gerichtet sind, verläßt der Strahl, der als runder Strahl in den Korrektor eintritt, diesen wieder als runder Strahl.

Mittels der vorgenannten Deformierungen des Strahls erfolgt auch die Farbfehlerkorrektur, wobei diese bezüglich eines Schnittes, beispielsweise des x-Schnittes, mit dem dritten Multipolelement und des anderen Schnittes, beispielsweise des y-Schnittes, mit dem vierten Multipolelement erfolgt. Die Funktion der Farbfehlerkorrektur entspricht dem bekannten Wienfilter und beruht darauf, daß die Quadrupolfelder aus sich überlagernden elektrischen und magnetischen Quadrupolfeldern bestehen. Die Feldstärken sind dabei so ausgelegt, daß Elektronen einer bestimmten Geschwindigkeit - also einer bestimmten Energie und in Relation zur Lichtoptik einer bestimmten Farbe - die Felder auf ihrem vorbestimmten Weg passieren. Die Elektronen abweichender Energien verlassen den vorbestimmten Weg und können damit den Farbfehler der Rundlinsen des Mikroskops, insbesondere der Objektivlinse, kompensieren. Nur für diese Farbfehlerkorrektur ist daher die Kombination aus elektrischem und magnetischem Feld erforderlich.

Bezüglich der Öffnungsfehler erfolgt die Korrektur ebenfalls im dritten und vierten Multipolelement mittels deren Oktupolfelder. Die Öffnungsfehler kommen von den rotationssymmetrischen Linsen des Elektronenmikroskops, da diese in größerer Entfernung von der optischen Achse verlaufende Strahlen stärker beeinflussen. Dies führt dazu, daß die Strahlen im Bereich von Zwischenbildern keinen gemeinsamen Schnittpunkt mit der optischen Achse bilden. Im Bereich der astigmatischen Zwischenbilder lassen sich die Strahlen des jeweiligen Schnittes, der keinen Nulldurchgang hat, durch die Oktupolfelder derart beeinflussen, daß sich die Strahlen wieder in der Bildebene schneiden. Wird die Korrektur für die Strahlen eines jeden Schnittes nacheinander durchgeführt und diese Strahlen dann wieder zu einem runden Strahl zusammengeführt, ist die Öffnungsfehlerkorrektur erfolgt. Dabei ist es jedoch nicht nur möglich, Öffnungsfehler vorgeordneter Rundlinsen zu korrigieren, es können auch Fehler nachgeordneter Rundlinsen vorkompensiert werden. Dann wird dem Strahlengang ein derartiger Öffnungsfehler aufgeprägt, daß er sich mit den Öffnungsfehlern der nachgeordneten Rundlinsen, beispielsweise des Objektivs, wieder aufhebt.

Mit diesen vorbekannten Korrekturen tritt jedoch das Problem auf, daß der Korrektor seinerseits wiederum Fehler verursacht. Dabei handelt es sich vor allem um unrunde Fehler, insbesondere um einen vierzähligen Astigmatismus dritter Ordnung und einen Sternfehler fünfter Ordnung. Die unrunden Fehler bilden axiale Bildfehlerfiguren wie Astigmatismus, Sternfehler, Rosettenfehler und Koma, die in verschiedenen Ordnungen auftreten. Was weiterhin als runder Fehler verbleibt, ist ein Öffnungsfehler fünfter Ordnung, der, wie oben beschrieben, durch die Konstellation von astigmatischen Zwischenbildern der außeraxialen Fundamentalbahnen und gleichzeitigem Maximum je einer axialen Fundamentalbahn im dritten und vierten Multipol weitgehend beseitigt wird.

Weiterbildungen der Erfindung dienen einer noch besseren Fehlerkompensation, insbesondere zur weiteren Verringerung von Fehlern höherer Ordnung.

Zu diesem Zweck wird ein weiteres Multipolelement vorgeschlagen, das am optimalsten in einem Bereich angeordnet wird, in dem die axialen Fundamentalbahnen x_{α} und y_{β} zusammenfallen. Dafür gibt es zwei Möglichkeiten:

Außerhalb der Multipolelemente, weil das erste Multipolelement die Fundamentalbahnen x_{α} und y_{β} erst trennt beziehungsweise das sechste Multipolelement diese wieder zusammenführt.

Oder in der Symmetrieebene, weil sich dort die axialen Fundamentalbahnen x_{α} und y_{β} schneiden.

Erzeugt man mit dem weiteren Multipolelement ein Oktupolfeld, so läßt sich mit diesem, also durch die Einstellung einer entsprechenden Feldstärke, ein Astigmatismus 3. Ordnung weitgehend kompensieren.

Um darüber hinaus auch alle Fehler bis zur fünften Ordnung bis auf kleine Restfehler zu kompensieren, wird vorgeschlagen, daß das weitere Multipolelement - unabhängig davon, welche der oben genannten Anordnung gewählt wurde - und das dritte sowie das vierte Multipolelement Zwölfpolfelder erzeugen, um durch die entsprechende Einstellung derselben diese Korrekturen vorzunehmen.

Die nachfolgenden Weiterbildungen der Erfindung sehen vor, auch die noch vorhandenen Restfehler so weit wie möglich zu beseitigen. Diese kleinen Restfehler werden durch die sich außerhalb des Korrektors befindlichen Rundlinsen verursacht. Dabei handelt es sich insbesondere um einen zwar verminderten, aber doch noch störenden Öffnungsfehler fünfter Ordnung.

Dazu wird vorgeschlagen, dem Korrektor objektivseitig zwei als Rundlinsen ausgebildete Transferlinsen zuzuordnen, deren Felder so einstellbar sind, daß die runden Fehler höherer Ordnung verschwinden. Diese Maßnahme führt jedoch wiederum zu Fehlern, insbesondere wird die Korrektur des Öffnungsfehlers dritter Ordnung sowie die Farbfehlerkorrektur teilweise wieder rückgängig gemacht. Deshalb ist ein Nachjustieren der dritten und vierten Multipolelemente zweckmäßig, wobei sowohl die Quadrupolfelder als auch die Oktupolfelder nachzujustieren sind. Bei der Nachjustierung der Quadrupolfelder müssen die magnetischen und elektrischen Felder insoweit simultan verstellt werden, daß die Farbfehlerkorrektur - wie oben beschrieben - erhalten bleibt. Ein Abweichen von dieser Simultanverstellung ist jedoch insoweit erforderlich, als ein durch die Einstellung der Transferlinsen wiederauftretender Farbfehler nachkorrigiert werden muß.

Da die Einfügung der Transferlinsen sowie jede Verstellung, wie die vorgenannte Nachjustierung, den Strahlengang wieder verändert, ist es zweckmäßig, wiederauftretende Fehler höherer Ordnung durch eine Nachjustierung der Zwölfpolfelder der dritten und vierten Multipole und des Zwölfpolfeldes des zusätzlich zu den sechs Multipolelementen vorgesehenen weiteren Multipolelements zu beseitigen.

Da durch die Nachjustierung der dritten und vierten Multipolelemente sowie des zusätzlichen Multipolelements wieder runde Fehler höherer Ordnung entstehen, sind die Transferlinsen wieder nachzujustieren, und danach müssen wieder die Multipolelemente in vorbeschriebener Weise nachjustiert werden. Da jede Verstellung der vorgenannten Elemente in angegebener Weise wieder Fehler zum Entstehen bringt, muß in iterativer Weise eine Wiederholung der vorgenannten Einzelschritte erfolgen, bis alle Fehler auf ein für die gewünschte Bildgebung tolerierbares Maß reduziert sind.

Ein Korrektor der erfindungsgemäßen Art läßt sich prinzipiell in jedes Elektronenmikroskop einfügen. Besonders geeignet ist es jedoch für Elektronenmikroskope, die nach dem Rasterprinzip arbeiten, also Raster-Elektronenmikroskope (genannt SEM) und Raster-Transmissionselektronenmikroskope (genannt STEM). Der erfindungsgemäße Korrektor weist dabei die baulichen Voraussetzungen, wie den räumlichen Aufbau, die Wicklungen und Materialeigenschaften sowie die erforderlichen Einstellbereiche für Strom und/oder Spannung zur Erzeugung und Regulierung der Feldstärken der jeweiligen magnetischen und/oder elektrischen Felder auf, um die beschriebenen Einstellungen und Justierungen beziehungsweise Nachjustierungen vornehmen zu können.

Die Charakterisierung von Feldern des Korrektors dahingehend, daß Einstellungen und Justierungen beziehungsweise Nachjustierungen möglich sind, bedeutet daher folgendes: Die baulichen Ausgestaltungen von Elektroden und/oder Elektromagneten und deren Beaufschlagungsmöglichkeit mit Strom beziehungsweise Spannung muß derart sein, daß nach dem Einbau des Korrektors in ein Elektronenmikroskop die angegebenen Korrekturmaßnahmen möglich sind. Durchgefiihrt werden diese Einstellungen, Justierungen und Nachjustierungen nach dem Einbau und der Inbetriebnahme des jeweiligen Elektronenmikroskops, da die konkreten Einstellungen sowohl von der Bauart des Elektronenmikroskops als auch von den individuellen Linsenfehlern abhängt, welche auch bei Elektronenmikroskopen der gleichen Baureihen individuell auftreten, beispielsweise durch Maßungenauigkeiten und Materialinhomogenitäten. Auch muß beim Betrieb eines Elektronenmikroskops von Zeit zu Zeit eine Nachjustierung erfolgen, da schon geringste Verschmutzungen die optischen Eigenschaften verändern und eine solche erforderlich machen können. Realisiert ist die Erfindung in einem Korrektor, der diese Korrekturmöglichkeiten des Elektronenstrahls ermöglicht. Die Konkretisierung der baulichen Ausgestaltung des Korrektors sowie die konkret zur Verfügung gestellten Strom und/oder Spannungsbereiche, die für die Einstellungen und Korrekturen erforderlich sind, richten sich nach der Bauart des jeweiligen Elektronenmikroskops, insbesondere nach den jeweiligen Strahlspannungen der möglichen Arbeitsbereiche und der konkreten Ausgestaltung von Linsensystem und Rastereinrichtung.

Da die angegebenen Eigenschaften des erfindungsgemäßen Korrektors ihre Wirkung nach dem Einbau in ein Elektronenmikroskop entfalten, betrifft die Erfindung auch ein Raster-Elektronenmikroskop oder Raster-Transmissionselektronenmikroskop mit einem Korrektor der vorgenannten Art, bei dem eine Korrektur des Elektronenstrahls in vorbeschriebener Weise möglich ist.

Die Erfindung wird nachfolgend anhand der Zeichnung erläutert. Es zeigen
- **Fig. 1**: eine schematische Darstellung des erfindungsgemäßen Korrektors mit Hinweis auf Weiterbildungen,
- **Fig. 2**: entsprechend zu Fig. 1 den Strahlenverlauf in den Ebenen x und y sowie die Anordnung der Felder,
- **Fig. 3**: eine schematische Teilansicht eines Elektronenmikroskops mit einem Korrektor und
- **Fig. 4**: eine schematische Darstellung eines Zwölfpolelements, das alle vorgenannten Felder erzeugen kann.

**Fig. 1** zeigt eine schematische Darstellung des erfindungsgemäßen Korrektors 10. In Richtung des Strahlengangs 7 sind entlang der optischen Achse 11 ein erstes 1, ein zweites 2 und ein drittes Multipolelement 3 angeordnet. Nach einer Symmetrieebene 8 folgen dann drei Multipolelemente 4, 5, 6, wobei diese zu den Multipolelementen 1, 2 und 3 bezüglich der Anordnung symmetrisch sind und auch eine baugleiche symmetrische Zuordnung in Bezug auf die Symmetrieebene 8 aufweisen müssen. Dabei entspricht das Multipolelement 1 dem Multipolelement 6, das Multipolelement 2 dem Multipolelement 5 und das Multipolelement 4 dem Multipolelement 3.

In der Symmetrieebene 8 kann - als Weiterbildung des Grundgedankens der Erfindung - ein weiteres Multipolelement 14 (gestrichelt dargestellt) angeordnet sein. Als Alternative kann das weitere Multipolelement 14' (strichpunktiert dargestellt) auch außerhalb der sechs Multipolelemente 1, 2, 3, 4, 5 und 6 angeordnet werden.

**Fig. 2** zeigt den Strahlenverlauf des Korrektors 10 in zwei senkrecht aufeinanderstehenden Ebenen, also im x-Schnitt und im y-Schnitt mit den Strahlengängen der axialen Fundamentalbahnen x_{α} und y_{β} sowie der außeraxialen Fundamentalbahnen x_{γ} und y_{δ} Dabei verlaufen die Fundamentalbahnen x_{α} und x_{γ} in der x-Ebene und die Fundamentalbahnen y_{β} und y_{δ} in der y-Ebene, die senkrecht entlang der optischen Achse 11 auf der x-Ebene steht. Des weiteren zeigt Fig. 2 die Felder, welche durch die Multipolelemente 1, 2, 3, 4, 5 und 6 sowie das weitere Multipolelement 14 erzeugt werden. Der Strahlengang geht in Richtung des Pfeils 7 und die optische Achse 11 verläuft durch die "0" der senkrechten Skala.

Wie aus der Zusammenschau der Fig. 1 und 2 ersichtlich ist, sind das erste 1, das zweite 2, das fünfte 5 und das sechste Multipolelement 6 zur Erzeugung von Quadrupolfeldern 1', 2', 5' und 6' ausgebildet. Es kann sich dabei um elektrische oder magnetische Quadrupolfelder 1', 2', 5', 6' oder eine Kombination von beidem handeln. Die Multipolelemente 1, 2, 5 und 6 müssen dazu mindestens vier Elektromagnete und/oder vier Elektroden in axialsymmetrischer Anordnung zur optischen Achse 11 aufweisen.

Das dritte 3 und vierte Multipolelement 4 sind als Zwölfpolelemente ausgebildet, wobei sie elektrische und magnetische Quadrupolfelder 3', 4' erzeugen können, indem beispielsweise die Weicheisenkerne der Elektromagneten gleichzeitig als Elektroden dienen. Das dritte 3 und vierte Multipolelement 4 wird dabei derart mit Strom für die Elektromagneten bzw. mit einem Potential für die Elektroden beaufschlagt, daß diese magnetische Quadrupolfelder 3', 4' sowie elektrische Quadrupolfelder 3', 4' erzeugen, die derart zusammenwirken, daß die eingangs beschriebene Farbfehlerkorrektur erfolgen kann.

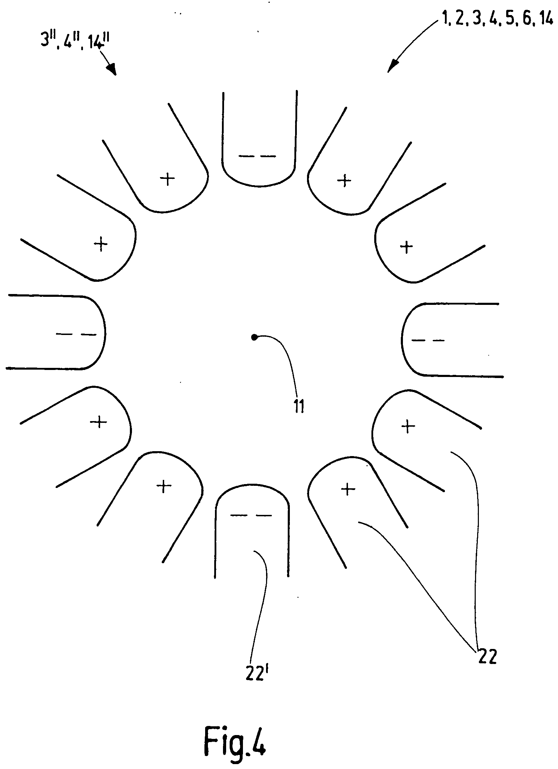

Weiterhin erzeugen das dritte und vierte Multipolelement 3, 4 Oktupolfelder 3", 4" sowie Zwölfpolfelder 3'" und 4"', welche ebenfalls elektrische oder magnetische Felder oder eine Kombination von beiden sein können. (Wie mit einem Zwölfpolelement ein Oktupolfeld erzeugbar ist, wird noch zu Fig. 4 erläutert). Weiterhin ist aus Fig. 2 noch das Oktupolfeld 14" des weiteren Multipolelements 14 sowie das durch dieses erzeugte Zwölfpolfeld 14"' ersichtlich.

Wesentlich für die Korrektur von Farbfehlern und Öffnungsfehlern ist zunächst die Bildung eines unrunden Strahlengangs, mit astigmatischen Zwischenbildern 12, 13, wobei hier die astigmatischen Zwischenbilder der außeraxialen Fundamentalbahnen x_{γ} und y_{δ} dazu dienen, die Korrekturen nach der Lehre von Scherzer (siehe oben) vorzunehmen.

Beim astigmatischen Zwischenbild 12 entsteht ein Strichfokus in y-Richtung, da die Strahlen des x-Schnittes einen Nulldurchgang aufweisen. Beim astigmatischen Zwischenbild 13 entsteht in entsprechender Weise ein Strichfokus in x-Richtung. Danach werden die Strahlengänge wieder zu einem runden Strahlenbündel x, y vereint.

Um diesen Strahlengang zu erzeugen, werden die sechs Quadrupolfelder 1', 2', 3', 4', 5' und 6' der Multipolelemente 1, 2, 3, 4, 5 und 6 eingesetzt, welche wie kombinierte Zylinder- und Rundlinsen in der Lichtoptik wirken. Dabei führt das Quadrupolfeld 1' des ersten Multipolelements 1 die außeraxialen Fundamentalbahnen x_{γ} und y_{δ} der Schnitte x und y auseinander, jedoch nicht die axialen Fundamentalbahnen x_{α} und y_{β}. Da diese im ersten Quadrupolfeld 1' ein stigmatisches Zwischenbild 9 bilden, bleiben sie unbeeinflußt. Das Quadrupolfeld 2' des zweiten Multipolelements 2 führt dann die axialen Fundamentalbahnen x_{α} und y_{β} auseinander und ändert die Steigung der außeraxialen Fundamentalbahnen x_{γ} sowie y_{δ}. Dadurch werden im Quadrupolfeld 3' des dritten Quadrupolelements 3 zwei Ziele erreicht, nämlich ein Maximum der axialen Fundamentalbahn x_{α} und im selben Bereich ein astigmatisches Zwischenbild 12 der außeraxialen Fundamentalbahnen x_{γ} und y_{δ}. Diese Konstellation ist zum einen die oben erwähnte Bedingung für eine Verringerung der Kombinationsfehler 5. Ordnung und zum anderen wird dort mittels der zusammenwirkenden elektrischen und magnetischen Quadrupolfelder 3' eine Farbfehlerkorrektur und durch das Oktupolfeld 3" eine Öffnungsfehlerkorrektur vorgenommen. Diese Fehlerkorrekturen erfolgen zunächst in der ersten Schnittebene.

Der vorgenannte Strahlverlauf führt weiterhin in der Symmetrieebene 8 zu einem Schnittpunkt der axialen Fundamentalbahnen x_{α}, y_{β} bei entgegengesetzter Steigung und gleichzeitig dazu, daß in der Symmetrieebene 8 x_{γ} und y_{δ} betragsgleich mit unterschiedlicher Ausrichtung zur optischen Achse 11 sind. Daher kann durch das in der Symmetrieebene 8 angeordnete weitere Multipolelement 14 mittels des Oktupolfeldes 14" eine Korrektur des Astigmatismus 3. Ordnung vorgenommen werden. Außerdem wird durch das Zusammenwirken eines Zwölfpolfeldes 14"' des weiteren Multipolelements 14 mit den Zwölfpolfeldern 3'" und 4'" des dritten Multipolelements 3 und des vierten Multipolelements 4 eine Korrektur aller Fehler bis zur 5. Ordnung bewirkt.

Bei allen diesen Korrekturen muß angemerkt werden, daß jede Korrektur eines Fehlers wieder andere Fehler, allerdings in abgeschwächter Form, verursacht. Deshalb müssen hier wieder Nachkorrekturen erfolgen. Aus diesem Grund müssen alle Korrekturschritte nacheinander mehrmals erfolgen, um sich mit dem oben bereits erwähnten iterativen Verfahren einem Fehlerminimum von akzeptierbarer Größe anzunähern.

Nach der Symmetrieebene 8 setzt sich der Strahlverlauf in zwei unterschiedlichen Arten von Austauschsymmetrien fort:

Die axialen Fundamentalbahnen x_{α} und y_{β} weisen eine spiegelsymmetrische Austauschsymmetrie bezüglich der Symmetrieebene 8 auf. Dies heißt, daß die Fundamentalbahn y_{β} im y-Schnitt nach der Symmetrieebene 8 so verläuft, als wäre sie eine Spiegelung der Fundamentalbahn x_{α} im x-Schnitt vor der Symmetrieebene 8. In gleicher Weise verläuft auch die Fundamentalbahn x_{α} nach der Symmetrieebene 8 so, als wäre sie eine Spiegelung der Fundamentalbahn y_{β} vor der Symmetrieebene 8.

Die außeraxialen Fundamentalbahnen x_{γ} und y_{δ} weisen dagegen eine punktsymmetrische oder antisymmetrische Austauschsymmetrie auf. Das heißt, daß die Fundamentalbahn y_{δ} im y-Schnitt nach der Symmetrieebene 8 so verläuft wie eine punktgespiegelte Fundamentalbahn x_{γ} im x-Schnitt vor der Symmetrieebene 8. Dies entspricht einer Punktspiegelung um den Schnittpunkt der Symmetrieebene 8 mit der optischen Achse 11. In entsprechender Weise verläuft die Fundamentalbahn x_{γ} nach der Symmetrieebene 8 so wie eine punktgespiegelte Fundamentalbahn y_{δ} vor der Symmetrieebene 8.

Dies wird dadurch erreicht, daß die Quadrupolfelder 4', 5' und 6' der Multipolelemente 4, 5 und 6 zu den Quadrupolfeldern 3', 2' und 1' der Multipolelemente 3, 2 und 1 paarweise betragsgleich, aber vorzeichenverschieden (d. h. um 90° gedreht) sind. Die außeraxialen Fundamentalbahnen x_{γ} und y_{δ} bilden dabei ein weiteres astigmatisches Zwischenbild 13 im Quadrupolfeld 4' des vierten Multipolelements 4 und die axiale Fundamentalbahn y_{β} ein Maximum, wodurch die oben genannte Fehlerkorrektur auch in der zweiten Schnittebene erfolgt. Schließlich bilden dann die axialen Fundamentalbahnen x_{α} und y_{β} auch im Quadrupolfeld 6' des sechsten Quadrupolelements wieder ein stigmatisches Zwischenbild 9'.

Die Schnitte x und y dienen natürlich nur der Darstellung der Strahlverformung, welche man sich räumlich vorstellen muß. Bei derartigen unrunden Feldern, verhält es sich wie bei den Zylinderlinsen in der Lichtoptik, wo es ebenfalls möglich ist, durch die Anordnung entgegenwirkender Zylinderlinsen die herbeigeführte Verzeichnung des Strahlengangs wieder zu eliminieren. Das ganze dient dazu, Farbfehler und Öffnungsfehler eines Elektronenstrahls nach dem Scherzer-Theorem zu korrigieren.

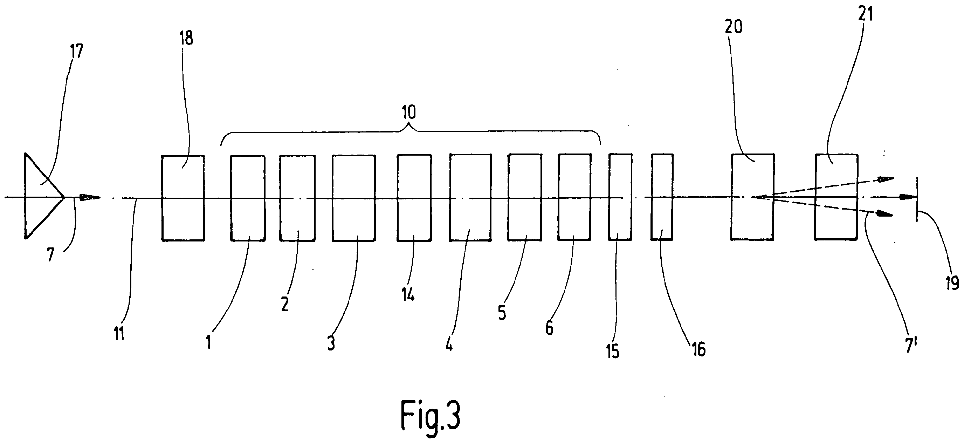

**Fig. 3** zeigt eine schematische Teilansicht eines Elektronenmikroskops, das ein Raster-Elektronenmikroskop oder ein Raster-Transmissionselektronenmikroskop sein kann. Der erfindungsgemäße Korrektor 10 wird im Strahlengang 7 nach der Strahlenquelle 17 und der Kondensorlinse 18 eingefügt. Nach dem Korrektor 10 folgen die Transferlinsen 15 und 16 mit deren Rundlinsenfeldern, wobei mit der oben beschriebenen iterativen Einstellung die Korrekturqualität des Korrektors 10 weiter verbessert werden kann.

Nach den Transferlinsen 15 und 16 folgt das Ablenksystem 20 zur Erzeugung des abgelenkten Strahls 7', also des Rasterstrahls, welcher mittels des Objektivs 21 auf das Objekt 19 gerichtet wird. Durch Abscannen mit dem Rasterstrahl 7' wird ein Bild vom Objekt 19 erzeugt.

Dabei erfolgt die Bilderzeugung beim Raster-Transmissionselektronenmikroskop (übliche Bezeichnung: "STEM" - scanning transmission electron microscope) dadurch, daß der Rasterstrahl 7' eine Dünnschnittprobe durchstrahlt und damit ein Bild erzeugt wird. Beim Rasterelektronenmikroskop (übliche Bezeichnung: "SEM"- scanning electron microscope) werden durch den Rasterstrahl 7' vom Objekt 19 Sekundärelektronen zurückgestrahlt. Diese werden mittels eines nicht dargestellten Detektors erfaßt und zur Bilderzeugung genutzt. Heute werden oft Elektronenmikroskope, die nach dem Rasterprinzip arbeiten, derart gebaut, daß sie als Raster-Transmissionselektronenmikroskop oder als Raster-Elektronenmikroskop nach dem Reflektionsprinzip arbeiten können. Der erfindungsgemäße Korrektor 10 ist für beide Arbeitsweisen gut geeignet.

Fig. 4 zeigt eine schematische Darstellung eines Multipolelements, wobei es sich um eines der Multipolelemente 1, 2, 3, 4, 5, 6 oder das weitere Multipolelement 14 oder 14' handeln kann. Zwölf Pole 22, 22' sind achssymmetrisch um die optische Achse 11 angeordnet. Wird damit ein Zwölfpolfeld 3"', 4'" oder 14"' erzeugt, so sind die Pole 22, 22' der Reihe nach immer abwechselnd als Nord- und Südpole zur Erzeugung von magnetischen Feldern oder als negativ und positiv geladene Elektroden zur Erzeugung von elektrischen Feldern ausgebildet.

Soll eine Kombination eines elektrischen und eines magnetischen Feldes erzeugt werden, so dienen die Weicheisenkerne der Elektromagneten gleichzeitig als Elektroden, die mit einer Spannung beaufschlagt sind.

Soll ein Quadrupolfeld 1', 2', 3', 4', 5' oder 6' erzeugt werden, so sind immer drei Elektromagneten oder Elektroden 28, 28' mit gleicher Polarität oder Ladung zusammengefaßt und die Dreiergruppen wechseln als Nord- und Südpole oder als negativ beziehungsweise positiv geladene Elektroden ab. Auch dabei können elektrische und magnetische Felder überlagert sein. Eine solche Überlagerung kann, wie oben zur Farbfehlerkorrektur mittels der magnetischen und elektrischen Felder 3' und 4' ausgeführt, einem Zusammenwirken in der Art eines Wienfilters dienen. Ein solches Zusammenwirken kann aber auch einer Feldverstärkung dienen.

Selbstverständlich können Multipolelemente, die, wie die Multipolelemente 1, 2, 5 und 6, ausschließlich Quadrupolfelder 1', 2', 5' und 6' erzeugen müssen, auch einfacher aufgebaut sein, indem sie nur vier Pole 22, 22' aufweisen, deren Polarität abwechselt.

Sollen dagegen Oktupolfelder 3", 4" oder 14" erzeugt werden, so müssen sich die Pole 22, 22' wie durch die "+" und "-" Zeichen dargestellt, abwechseln. Es folgen also zwei positiv geladene Elektroden 22 und eine negativ geladene Elektrode 22' in abwechselnder Reihe, wobei die negative Ladung (wie durch die zwei "-" Zeichen symbolisiert) entsprechend verstärkt sein muß, um ein möglichst unverzerrtes Oktupolfeld 3", 4" oder 14" zu erzielen. Bei der Erzeugung eines magnetischen Oktupols verhält sich dies dann entsprechend. Selbstverständlich kann die genannte abwechselnde Reihe auch mit umgekehrten Ladungen ausgestaltet sein.

Überlagerte Felder, wie Quadrupolfeld, Oktupolfeld und Zwölfpolfeld, erzeugt durch ein einziges Zwölfpolelement, erhält man dadurch, daß in den jeweiligen Polen 22, 22'- also in den Elektromagneten oder Elektroden - die Ströme bzw. Spannungen aufsummiert werden. Auf diese Weise lassen sich alle oben erwähnten Feldüberlagerungen herstellen.

### Bezugszeichenliste

- 1, 2, 3, 4, 5, 6: Multipolelemente
- 1', 2', 3', 4', 5', 6': Quadrupolfelder der Multipolelemente
- 3", 4": Oktupolfelder der Multipolelemente 3 und 4
- 3"', 4"': Zwölfpolfelder der Multipolelemente 3 und 4
- 7: Strahlengang
- 7': abgelenkter Strahl (Rasterstrahl)
- 8: Symmetrieebene
- 9, 9': stigmatische Zwischenbilder der axialen Fundamentalbahnen x_{α} und y_{β}
- 10: Korrektor
- 11: optische Achse
- 12, 13: astigmatische Zwischenbilder der außeraxialen Fundamentalbahnen x_{γ} und y_{δ}
- 14: weiteres Multipolelement (in der Symmetrieebene 8 angeordnet)
- 14': weiteres Multipolelement (außerhalb der Multipolelemente 1, 2, 3, 4, 5, 6 angeordnet)
- 14": Oktupolfeld des weiteren Multipolelements 14
- 14"': Zwölfpolfeld des weiteren Multipolelements 14
- 15, 16: Transferlinsen
- 17: Strahlquelle
- 18: Kondensorlinse
- 19: Objekt
- 20: Ablenksystem
- 21: Objektiv
- 22: Pole, als Elektromagnet und/oder Elektrode ausgebildet - Südpol der positiv geladenen Elektrode
- 22': Pole, als Elektromagnet und/oder Elektrode ausgebildet - Nordpol der negativ geladenen Elektrode

- x, y: Schnitt
- x_{α}, y_{β}: axiale Fundamentalbahnen
- x_{γ}, y_{δ}: außeraxiale Fundamentalbahnen

## Patentansprüche

1. Korrektor (10) für die Farb- und Öffnungsfehlerkorrektur bei einem Elektronenmikroskop mit im Strahlengang (7) nacheinander symmetrisch zu einer Symmetrieebene (8) angeordneten sechs Multipolelementen (1, 2, 3, 4, 5, 6), von denen alle zur Erzeugung von Quadrupolfeldern (1', 2', 3', 4', 5', 6') und das dritte (3) und vierte (4) auch zur Erzeugung von Oktupolfeldern (3", 4") dienen, wobei letztere gleichgerichtet und die Quadrupolfelder (1', 2', 3', 4', 5', 6') aller sechs Multipolelemente (1, 2, 3, 4, 5, 6) von einem zum nächsten um 90° gedreht und bezüglich ihrer Feldstärken punktsymmetrisch zum Schnittpunkt der optischen Achse (11) mit der Symmetrieebene (8) sind, wobei die folgenden Austauschsymmetrien entstehen, eine Austauschsymmetrie der axialen Fundamentalbahnen (x_{α}, y_{β}) mit der Symmetrieebene (8) als Spiegelebene für den Austausch des Verlaufs der axialen Fundamentalbahnen x_{α} und y_{β}, sowie eine Austauschsymmetrie der außeraxialen Fundamentalbahnen (x_{γ}, y_{δ}) mit dem Schnittpunkt der optischen Achse (11) mit der Symmetrieebene (8) als Punkt für einen punktsymmetrischen Austausch des Verlaufs der außeraxialen Fundamentalbahnen x_{γ} und y_{δ} und wobei danach alle Fundamentalbahnen (x_{α}, y_{β}, x_{γ}, y_{δ}) am Ende des Korrektors (10) wieder zusammengeführt werden, wobei durch das Zusammenwirken der als magnetische und elektrische Felder (3', 4') ausgebildeten Quadrupolfelder (3', 4') des dritten (3) und vierten (4) Multipolelements eine Farbfehlerkorrektur sowie mittels der Quadrupolfelder (1', 2', 3', 4', 5', 6') und der Oktupolfelder (3", 4") eine Öffnungsfehlerkorrektur möglich ist,
**dadurch gekennzeichnet,**
**daß** im Quadrupolfeld (1') des ersten Quadrupolelements (1) ein stigmatisches Zwischenbild (9) der axialen Fundamentalbahnen (x_{α}, y_{β}) entsteht und dieses Quadrupolfeld (1') derart eingestellt ist, daß astigmatische Zwischenbilder (12, 13) der außeraxialen Fundamentalbahnen (x_{γ}, y_{δ}) im Bereich der Mitte der Quadrupolfelder (3', 4') des dritten (3) und vierten Multipolelements (4) entstehen und dort auch durch die Einstellung des Quadrupolfeldes (2') des zweiten Quadrupolelements (2) die axialen Fundamentalbahnen (x_{α}, y_{β}) des gleichen Schnitts (x, y), in dem die Zwischenbilder (12, 13) der außeraxialen Fundamentalbahnen (x_{γ}, y_{δ}) liegen, jeweils ein Maximum aufweisen.

2. Korrektor nach Anspruch 1,
**dadurch gekennzeichnet,**
**daß** ein weiteres Multipolelement (14') außerhalb der Multipolelemente (1, 2, 3, 4, 5, 6) angeordnet ist.

3. Korrektor nach Anspruch 1,
**dadurch gekennzeichnet,**
**daß** ein weiteres Multipolelement (14) in der Symmetrieebene (8) angeordnet ist.

4. Korrektor nach Anspruch 2 oder 3,
**dadurch gekennzeichnet,**
**daß** das weitere Multipolelement (14 oder 14') zur Korrektur eines Astigmatismus 3. Ordnung ein Oktupolfeld (14") erzeugt.

5. Korrektor nach Anspruch 2, 3 oder 4,
**dadurch gekennzeichnet,**
**daß** zur Korrektur aller Fehler bis zur 5. Ordnung das weitere Multipolelement (14 oder 14') und das dritte und vierte Multipolelement (3, 4) Zwölfpolfelder (3"', 4"', 14"') erzeugen.

6. Anordnung mit einem Korrektor nach einem der Ansprüche 1 bis 5,
**dadurch gekennzeichnet,**
**dass** die Anordnung ferner zwei als Rundlinsen ausgebildete Transferlinsen (15, 16) enthält, die dem Korrektor (10) objektivseitig zugeordnet sind, und deren Felder so einstellbar sind, daß die runden Fehler höherer Ordnung verschwinden.

7. Anordnung nach Anspruch 6,
**dadurch gekennzeichnet,**
**daß** eine Nachjustierung der Quadrupol- (3', 4') und Oktupolfelder (3", 4") des dritten (3) und vierten Multipolelements (4) und des Oktupolfeldes (14") des weiteren Multipolelements (14, 14') möglich ist, derart, daß der durch die vorgenannte Einstellung der Transferlinsen (15, 16) erneut verursachte Farbfehler erster und Öffnungsfehler dritter Ordnung wieder beseitigt sind.

8. Anordnung nach Anspruch 7,
**dadurch gekennzeichnet,**
**daß** eine Nachjustierung der Zwölfpolfelder (3"', 4"', 14"') des dritten (3) und vierten Multipolelements (4) und des weiteren Multipolelements (14, 14') möglich ist, um die durch die Transferlinsen (15, 16) und die vorgenannte Nachjustierung wieder aufgetretenen Fehler höherer Ordnungen wieder zu beseitigen.

9. Anordnung nach Anspruch 6, 7 und 8,
**dadurch gekennzeichnet,**
**daß** eine Beseitigung der Farbfehler erster und Öffnungsfehler dritter sowie Fehler höherer Ordnung durch eine Nachjustierung von Transferlinsen (15, 16), Quadrupolfeldern (3', 4') und Oktupolfeldern (3", 4", 14") und danach von Zwölfpolfeldern (3"', 4"', 14"') sowie eine iterative Einstellung in den vorgenannten Schritten zur Verminderung der durch die jeweils vorangegangenen Nachjustierungen wiederum verursachten Fehler möglich ist.

10. Raster-Elektronenmikroskop oder Raster-Transmissionselektronenmikroskop,
**gekennzeichnet durch**
eine Korrektur des Elektronenstrahls mittels eines Korrektors (10) nach einem der Ansprüche 1 bis 5 oder einer Anordnung nach einem der Ansprüche 6 bis 9.

## Claims

1. Corrector (10) for chromatic and spherical aberration in an electron microscope with six multipole elements (1, 2, 3, 4, 5, 6) arranged successively in the beam path (7) symmetrically to a plane of symmetry (8), all of which are used for the production of quadrupole fields (1', 2', 3', 4', 5', 6') and the third (3) and fourth (4) also for the production of octupole fields (3", 4"), wherein said fields are commutated and the quadrupole fields (1', 2', 3', 4', 5', 6') of all six multipole elements (1, 2, 3, 4, 5, 6) are rotated through 90° from one to the next and, in relation to their field strengths, are point symmetrical to the intersection of the optical axis (11) with the plane of symmetry (8), wherein the following exchange symmetries result, an exchange symmetry of the axial fundamental paths (xα, yβ) with the plane of symmetry (8) as the plane of symmetry for the exchange of the profile of the axial fundamental paths xα and yβ and also an exchange symmetry of the off-axial fundamental paths (xγ, yδ) with the intersection of the optical axis (11) with the plane of symmetry (8) as the point for a point symmetrical exchange of the profile of the off-axial fundamental paths xγ and yδ and wherein thereafter all fundamental paths (xα, yβ, xγ, yδ) are brought together again at the end of the corrector (10), wherein through the interaction of the quadrupole fields (3', 4') of the third (3) and fourth (4) multipole element configured as magnetic and electrical fields (3', 4'), a chromatic aberration correction is possible and also by means of the quadrupole fields (1', 2', 3', 4', 5', 6') and the octupole fields (3", 4") a spherical aberration correction is possible
**characterized in that**
in the quadrupole field (1') of the first quadrupole element (1) a stigmatic intermediate image (9) of the axial fundamental paths (xγ, yδ) is produced and this quadrupole field (1') is adjusted in such a manner that astigmatic intermediate images (12, 13) of the off-axial fundamental paths (xγ, yδ) in the region of the middle of the quadrupole fields (3', 4') of the third (3) and fourth multipole element (4) are generated and there too, the adjustment of the quadrupole field (2') of the second quadrupole element (2) means that the axial fundamental paths (xα, yβ) of the same section (x, y), in which the intermediate images (12, 13) of the off-axial fundamental paths (xγ, yδ) lie, are at a maximum in each case.

2. The corrector according to claim 1,
**characterized in that**
a further multipole element (14') is arranged outside the multipole elements (1, 2, 3, 4, 5, 6).

3. The corrector according to claim 1,
**characterized in that**
a further multipole element (14) is arranged in the plane of symmetry (8).

4. The corrector according to claim 2 or 3,
**characterized in that**
the further multipole element (14 or 14') produces an octupole field (14") to correct a third-order astigmatism.

5. The corrector according to claim 2, 3 or 4,
**characterized in that**
in order to correct all aberrations up to the fifth order, the further multipole element (14 or 14') and the third and fourth multipole element (3, 4) produce twelve-pole fields (3"', 4"', 14"').

6. An assembly with a corrector according to one of claims 1 to 5,
**characterized in that**
the assembly further contains two transfer lenses (15, 16) configured as round lenses which are assigned to the corrector (10) on the lens side and the fields of which can be adjusted in such a manner that the higher-order round aberrations disappear.

7. The assembly according to claim 6,
**characterized in that**
a readjustment of the quadrupole fields (3', 4') and octupole fields (3", 4") of the third (3) and fourth multipole element (4) and of the octupole field (14") of the further multipole element (14, 14') is possible in such a manner that the first-order chromatic aberrations and third-order spherical aberrations caused by the aforementioned adjustment of the transfer lenses (15, 16) are removed again.

8. The assembly according to claim 7,
**characterized in that**
a readjustment of the twelve-pole fields (3"', 4"', 14"') of the third (3) and fourth multipole element (4) and of the further multipole element (14, 14') is possible, in order to remove the higher-order aberrations that have recurred due to the transfer lenses (15, 16) and the aforementioned readjustment once again.

9. The assembly according to claim 6, 7 and 8,
**characterized in that**
a removal of the first-order chromatic aberration and the third-order spherical aberration and also higher-order aberrations through a readjustment of transfer lenses (15, 16), quadrupole fields (3', 4') and octupole fields (3", 4", 14") and thereafter of twelve-pole fields (3"', 4"', 14"') and also an iterative adjustment in the aforementioned steps to reduce the aberrations caused by the preceding readjustments in each case.

10. A scanning electron microscope or scanning transmission electron microscope,
**characterized by**
a corrector of the electron beam by means of a corrector (10) according to one of claims 1 to 5 or an assembly according to one of claims 6 to 9.

## Revendications

1. Correcteur (10) destiné à corriger les erreurs de coloration et d'ouverture sur un microscope électronique, avec six éléments multipolaires (1, 2, 3, 4, 5, 6) situés les uns derrière les autres en symétrie en un plan de symétrie (8) dans la trajectoire de faisceau (7), dont tous servent à créer des champs quadripolaires (1', 2', 3', 4', 5', 6') et le troisième (3) et le quatrième (4) servent aussi à créer des champs octopolaires (3", 4"), les derniers étant alignés et les champs quadripolaires (1', 2', 3', 4', 5', 6') de tous les six éléments multipolaires (1, 2, 3, 4, 5, 6) étant tournés de 90° de l'un à l'autre et au niveau de leurs intensités de champ, étant en symétrie ponctuelle par rapport au point d'intersection de l'axe optique (11) avec le plan de symétrie (8), les symétries d'échange suivantes se créant, une symétrie d'échange des trajectoires fondamentales (x_{α}, y_{β}) axiales avec le plan de symétrie (8), en tant que plan spéculaire pour l'échange du trajet des trajectoires fondamentales axiales x_{α} et y_{β}, ainsi qu'une symétrie d'échange des trajectoires fondamentales (x_{γ}, y_{δ}) extra-axiales avec le point d'intersection de l'axe optique (11) avec le plan de symétrie (8), en tant que point pour un échange en symétrie ponctuelle du trajet des trajectoires fondamentales (x_{γ}, y_{δ}) extra-axiales et ensuite toutes les trajectoires fondamentales (x_{α}, y_{β}, x_{γ}, y_{δ}) étant de nouveau réunies à la fin du correcteur (10), par l'interaction des champs quadripolaires (3', 4') conçus en tant que champs magnétiques et électriques (3', 4') du troisième (3) et du quatrième (4) élément multipolaires, une correction d'erreurs de coloration, ainsi qu'au moyen des champs quadripolaires (1', 2', 3', 4', 5', 6') et des champs octopolaires (3", 4"), une correction des erreurs d'ouverture étant possibles,
**caractérisé en ce que**,
dans le champ quadripolaire (1') du premier élément quadripolaire (1), il se créé une image intermédiaire stigmatique (9) des trajectoires fondamentales (x_{α}, y_{β}) axiales et **en ce que** ledit champ quadripolaire (1') est réglé de telle sorte que des images intermédiaires astigmatiques (12, 13) des trajectoires fondamentales (x_{γ}, y_{δ}) extra-axiales se créent dans la région du centre des champs quadripolaires (3', 4') du troisième (3) et du quatrième élément multipolaire (4) et là-bas, également par le réglage du champ quadripolaire (2') du deuxième élément quadripolaire (2), les trajectoires fondamentales x_{α}, y_{β}) axiales de la même coupe (x, y), dans lesquelles se situent les images intermédiaires (12, 13) des trajectoires fondamentales (x_{γ}, y_{δ}) extra-axiales présentent chacune un maximum.

2. Correcteur selon la revendication 1,
**caractérisé en ce qu'**un élément multipolaire (14') supplémentaire est placé à l'extérieur des éléments multipolaires (1, 2, 3, 4, 5, 6).

3. Correcteur selon la revendication 1,
**caractérisé en ce qu'**un élément multipolaire (14) supplémentaire est placé dans le plan de symétrie (8).

4. Correcteur selon la revendication 2 ou 3,
**caractérisé en ce que** pour corriger un astigmatisme de 3^{ème} ordre, l'élément multipolaire (14 ou 14') supplémentaire créé un champ octopolaire (14").

5. Correcteur selon la revendication 2, 3 ou 4,
**caractérisé en ce que** pour corriger toutes les erreurs jusqu'au 5^{ème} ordre, l'élément multipolaire (14 ou 14') et le troisième et quatrième éléments multipolaires (3, 4) créent des champs dodécapolaires (3"', 4"', 14"').

6. Agencement avec un correcteur selon l'une quelconque des revendications 1 bis 5,
**caractérisé en ce que** l'agencement contient en outre deux lentilles de transfert (15, 16) conçues en tant que lentilles rondes, qui sont associées au correcteur (10), côté objectif et dont les champs sont réglables de telle sorte que les erreurs rondes d'ordre plus élevé disparaissent.

7. Agencement selon la revendication 6,
**caractérisé en ce qu'**un réajustage des champs quadripolaires (3', 4') et octopolaires (3", 4") du troisième (3) et quatrième éléments multipolaires (4) et du champ octopolaire (14") du quatrième élément multipolaire (14, 14') est possible, de telle sorte que l'erreur de coloration de nouveau générée par le réglage précédemment cité des lentilles de transfert (15, 16) de premier ordre et des erreurs d'ouverture de troisième ordre soient de nouveau éliminées.

8. Agencement selon la revendication 7,
**caractérisé en ce qu'**un réajustage des champs dodécapolaires (3"', 4"', 14"') du troisième (3) et du quatrième éléments multipolaires (4) et de l'élément multipolaire (14, 14') supplémentaire est possible, pour éliminer de nouveau les erreurs d'ordre plus élevé produites une fois encore par les lentilles de transfert (15, 16) et le réajustage précédemment cité.

9. Agencement selon la revendication 6, 7 et 8,
**caractérisé en ce qu'**une élimination des erreurs de coloris de premier ordre et d'erreurs d'ouverture de troisième ordre, ainsi que d'erreurs d'ordres plus élevés est possible par un réajustage de lentilles de transfert (15, 16), de champs quadripolaires (3', 4') et de champs octopolaires (3", 4", 14") et ensuite, de champs dodécapolaires (3"', 4"', 14"'), ainsi qu'un réglage itératif dans les étapes précédemment citées pour la réduction des erreurs provoquées une fois encore par les réajustages respectivement précédents sont possibles.

10. Microscope électronique à balayage ou microscope électronique à transmission à balayage,
**caractérisé par** une correction du faisceau électronique à l'aide d'un correcteur selon l'une quelconque des revendications 1 à 5 ou un agencement selon l'une quelconque des revendications 6 à 9.
